# EUROPÄISCHE PATENTSCHRIFT

(11) **EP 1 639 717 B1**
(45) Veröffentlichungstag und Bekanntmachung des Hinweises auf die Patenterteilung: **10.08.2016**
(21) Anmeldenummer: 04740063.5
(22) Anmeldetag: 18.06.2004
(51) Int. Cl.: H03H 7/24, H03H 11/24

(54) **EICHLEITUNGS-ANORDNUNG**
ATTENUATOR SYSTEM
ENSEMBLE CIRCUIT D'ETALONNAGE

(30) Priorität: 27.06.2003 DE 10329089; 18.07.2003 DE 10332808
(43) Veröffentlichungstag der Anmeldung: 29.03.2006
(73) Patentinhaber: Rohde & Schwarz GmbH & Co. KG, 81671 München (DE)
(72) Erfinder: NÖST, Peter, 81735 München (DE); KRAEMER, Wilhelm, 83435 Bad Reichenhall (DE)
(74) Vertreter: Körfer, Thomas
(86) Internationale Anmeldenummer: PCT/EP2004/006618
(87) Internationale Veröffentlichungsnummer: WO 2005/002072

(56) Entgegenhaltungen:
- EP-A- 0 208 441
- EP-A- 0 762 638
- EP-A- 0 998 032
- DE-A- 10 063 999
- PATENT ABSTRACTS OF JAPAN Bd. 1995, Nr. 04, 31. Mai 1995 (1995-05-31) & JP 7 022999 A (SANYO ELECTRIC CO LTD), 24. Januar 1995 (1995-01-24)
- DATABASE WPI Section EI, Week 200307 Derwent Publications Ltd., London, GB; Class S01, AN 2003-073317 XP002302755 & KR 2002 059 463 A (LG INNOTEC CO LTD) 13. Juli 2002 (2002-07-13)

## Beschreibung

Die Erfindung betrifft eine Eichleitungs-Anordnung zum Einstellen der Ausgangsleistung einer Hochfrequenz-Signalquelle.

Eichleitungen zum Einstellen der Ausgangsleistung von Hochfrequenz-Signalquellen wie Signalgeneratoren sind in den verschiedenartigsten Ausführungsformen bekannt. Durch stufenweises Zu- und Abschalten von Dämpfungsgliedern kann die Durchgangsdämpfung einer solchen Eichleitung in einem großen Dynamikbereich eingestellt werden. Das Verbinden der einzelnen Dämpfungsglieder zu T- oder Pi-Schaltungen erfolgt durch Umschalter, die in modernen Geräten als elektronische Schalter ausgebildet sind. Solche mittels elektronischer Schalter wie PIN-Dioden oder Transistoren, beispielsweise Galliumarsenid-MESFET-Transistoren schaltbare Eichleitungen werden als elektronische Eichleitungen bezeichnet.

Eine solche elektronische Eichleitung ist z. B. aus der DE 100 63 999 A1 bekannt.
Der Vorteil solcher elektronischer Eichleitungen liegt in der höheren Schaltgeschwindigkeit sowie einer wesentlich geringeren Abhängigkeit der Lebensdauer von der Anzahl der Schaltzyklen im Vergleich zu Eichleitung mit mechanischen Schalt-Relays. Ein Nachteil der elektronischen Eichleitung ist jedoch ihre relativ hohe Einfügungsdämpfung (Mindestdämpfung, Grunddämpfung) von beispielsweise bis zu 5 dB und ihre geringere Linearität. Auch die maximale Ausgangsleistung ist geringer als bei mechanischen Eichleitungen mit mechanischen Umschaltern.

JP 7022999 A beschreibt eine Eichleitungs-Anordnung zum Einstellen der Ausgangsleistung einer HF-Signalquelle, wobei zwischen der Signalquelle und einem Ausgang über ein-und ausgangsseitige mechanische Umschalter eine elektronische Eichleitung angeordnet ist und diese mechanischen Umschalter derart schaltbar sind, dass in der einen Schaltstellung die elektronische Eichleitung und in der anderen Schaltstellung eine direkte Umgehungsleitung zwischen Signalquelle und Ausgang geschaltet ist.

Es ist die Aufgabe der Erfindung, eine Eichleitungs-Anordnung zu schaffen, welche die vorteilhaften Eigenschaften einer elektronischen Eichleitung mit einer geringen Einfügungsdämpfung verbindet. Diese Aufgabe wird ausgehend von einer Eichleitungs-Anordnung zum Einstellen der Ausgangsleistung einer Hochfrequenz-Signalquelle erfindungsgemäß durch die kennzeichnenden Merkmale des Hauptanspruches gelöst. Vorteilhafte Weiterbildungen ergeben sich aus den Unteransprüchen.

Durch die erfindungsgemäß mechanisch geschaltete Umgehungsleitung (Bypass) parallel zu einer üblichen elektronischen Eichleitung, die im wesentlichen nur aus zwei einfachen Koaxial-Umschaltern oder Transferschaltern mit einem diese verbindenden Koaxialleitungsstück besteht, kann für geringe Ausgangsleistung der Signalquelle in üblicher Weise die elektronische Eichleitung benutzt werden, für eine höhere Ausgangsleistung wird der mechanische Bypass eingeschaltet und die elektronische Eichleitung abgeschaltet, so daß dann die volle Ausgangsleistung der HF-Signalquelle über den praktisch dämpfungslosen Bypass zum Ausgang durchgeschaltet wird.

In dieser Bypass-Schaltstellung kann die Ausgangsleistung entweder durch den Ausgangsverstärker der Signalquelle eingestellt werden oder der Bypass selbst wird als mechanische Eichleitung ausgebildet, d. h. über zusätzliche mechanische Koaxial-Umschalter im Bypass kann zwischen zwei oder mehr unterschiedlichen Dämpfungsgliedern umgeschaltet werden und so die Ausgangsleistung auch für höhere Leistungen eingestellt werden.

Die zum Einschalten des Bypasses vorgesehenen beiden z. B. bistabilen Koaxial-Umschalter am Ein- und Ausgang der elektronischen Eichleitung können gemäß einer Weiterbildung der Erfindung gleichzeitig auch noch zum Zweck des Überspannungsschutzes ausgenutzt werden. Dazu ist es nur erforderlich, dem Ausgang der Signalquelle einen entsprechenden Überspannungsdetektor zuzuordnen, der beispielsweise beim Anlegen einer hohen Fremdspannung am Ausgang der Signalquelle über den ausgangsseitigen mechanischen Umschalter die elektronische Eichleitung vom Ausgang abschaltet, so daß die elektronische Eichleitung nur noch über den anderen mechanischen Umschalter mit der Signalquelle verbunden ist. Hierdurch werden irreversible Veränderung bzw. Beschädigungen der elektronischen Eichleitung der Signalquelle und weiterer Schaltungsteile durch eine Überspannung am Geräteausgang verhindert.

Die bei der erfindungsgemäßen Anordnung verwendeten Leitungen und mechanischen Schalter müssen selbstverständlich hochfrequenztauglich sein und sind daher als z. B. Koaxialleitungen, koaxiale Umschalter, Mehrfachumschalter oder Transferschalter mit definiertem Wellenwiderstand ausgeführt.

Die Erfindung wird im folgenden anhand einer schematischen Zeichnung an einem Ausführungsbeispiel näher erläutert. In der Zeichnung zeigt:

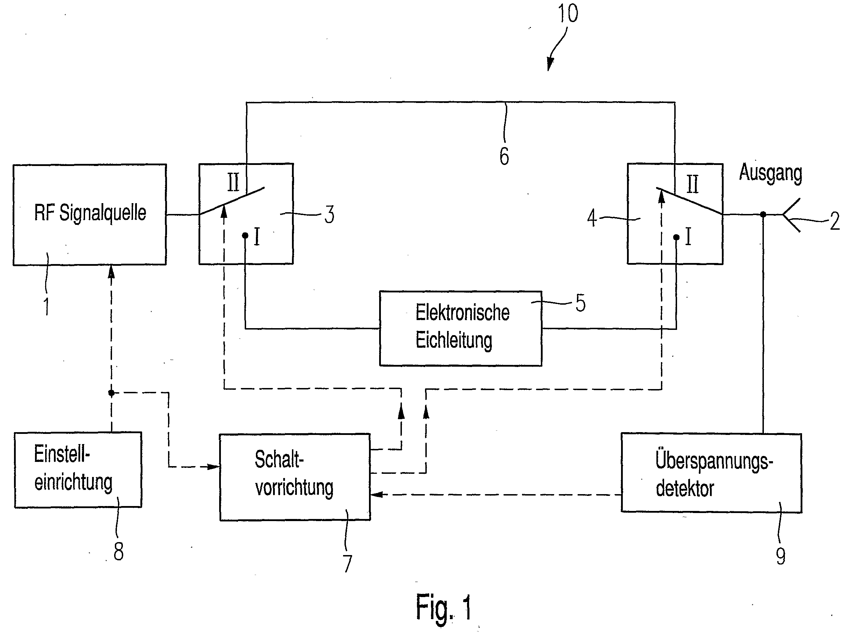

Fig. 1 ein Ausführungsbeispiel einer erfindungsgemäßen Eichleitungs-Anordnung.

Die Fig. 1 zeigt eine erfindungsgemäße Eichleitungs-Anordnung 10 zum Einstellen der Ausgangsleistung einer Hochfrequenz-Signalquelle 1, beispielsweise eines Signalgenerators, am Ausgang 2. Dazu ist zwischen der Signalquelle 1 und dem Ausgang 2 über eingangsseitige und ausgangsseitige mechanische Umschalter 3, 4 eine übliche elektronische Eichleitung 5 zwischengeschaltet, deren Dämpfungsglieder über Halbleiterelemente, beispielsweise Metall-Halbleiter-Feldeffekt-Transistoren (MESFET) zu- und abgeschaltet werden.

Die Dämpfung dieser elektronischen Eichleitung 5 ist beispielsweise im Bereich zwischen nominell 0 dB (real aufgrund der Grunddämpfung bzw. Einführungsdämpfung bis zu 5 dB) und 125 dB in 5 dB-Stufen im Frequenzbereich zwischen 100 kHz und 3 GHz variierbar. Parallel zu dieser elektronischen Eichleitung 5 ist zwischen den beiden mechanischen Umschaltern 3 und 4 eine koaxiale Bypassleitung 6 angeordnet. Die beiden Umschalter 3 und 4 sind beispielsweise mechanische Relay-Schalter (SPOT = Single Pole Double Through-Relays) ausgebildet und durch eine Schaltvorrichtung 7 gemeinsam schaltbar.

Diese Schaltvorrichtung 7 ist mit der Einstellvorrichtung 8 für die Ausgangsleistung der Signalquelle 1 derart verbunden, daß für geringe Ausgangsleistung unterhalb einer vorbestimmten Leistungsschwelle die beiden Relay-Umschalter 3 und 4 die Schaltstellung I einnehmen und dadurch die elektronische Eichleitung 5 zwischen Signalquelle 1 und Ausgang 2 schalten. Wird über die Einstelleinrichtung 8 der Signalquelle 1 eine höhere Ausgangsleistung eingestellt, so werden über die Schaltvorrichtung die beiden mechanischen Umschalter 3, 4 in die Schaltstellung II umgeschaltet und damit über die Bypass-Koaxialleitung 6 die Signalquelle 1 direkt zum Ausgang 2 durchgeschaltet. Damit steht dann die maximale Ausgangsleistung am Ausgang 2 zur Verfügung und wird nicht mehr durch die Grunddämpfung (Einfügungsdämpfung) der elektronischen Eichleitung gedämpft.

Wenn in diesem höheren Leistungsbereich eine weitere Feineinstellung der Ausgangsleistung gewünscht wird, so kann es vorteilhaft sein, die Bypass-Koaxialleitung 6 selbst noch als mechanische Eichleitung auszubilden und durch zusätzliche mechanische Umschalter beispielsweise zwei oder mehr Dämpfungsglieder in die Bypass-Leitung 6 einzuschalten.

Die Schaltvorrichtung 7 der mechanischen Umschalter 3, 4 kann vorteilhaft mit einem dem Ausgang 2 der Eichleitungs-Anordnung 1 zugeordneten Überspannungs-Detektor 9 derart verbunden sein, daß bei Überschreitung eines zulässigen Pegels am Ausgang 2 der ausgangsseitige mechanische Umschalter 4 die elektronische Eichleitung 5 vom Ausgang 2 abschaltet und der eingangsseitige mechanische Umschalter 3 die elektronische Eichleitung 5 an die Signalquelle 1 anschaltet.

Die erfindungsgemäße Eichleitungs-Anordnung 10 ist nicht nur für HF-Signalgeneratoren von Vorteil, sondern könnte mit der vorgesehenen Bypass-Leitung 6 auch bei anderen Meßgeräten wie Netzwerk- oder Spektrum-Analysatoren oder sogar bei Hochfrequenzempfängern in der Eingangsstufe benutzt werden, also überall dort, wo die relativ hohe Grunddämpfung und/oder die schlechtere Linearität einer elektronischen Eichleitung 5 stört.

## Patentansprüche

1. Eichleitungs-Anordnung (10) zum Einstellen der Ausgangsleistung einer HF-Signalquelle (1),
wobei zwischen der Signalquelle (1) und einem Ausgang (2) über ein- und ausgangsseitige mechanische Umschalter (3, 4) eine elektronische Eichleitung (5) angeordnet ist und diese mechanischen Umschalter derart schaltbar sind, dass in der einen Schaltstellung (I) die elektronische Eichleitung (5) und in der anderen Schaltstellung (II) eine direkte Umgehungsleitung (6) zwischen Signalquelle (1) und Ausgang (2) geschaltet ist,
**dadurch gekennzeichnet,**
**dass** mittels einer Schaltvorrichtung (7) der mechanischen Umschalter (3, 4) mit einem dem Ausgang (2) der Signalquelle (1) zugeordneten Überspannungs-Detektor (9) derart verbindbar ist, dass bei Überschreitung eines zulässigen Pegels am Ausgang (2) der ausgangsseitige mechanische Umschalter (4) die elektronische Eichleitung (5) vom Ausgang (2) abschaltet und der eingangsseitige mechanische Umschalter (3) die elektronische Eichleitung (5) an die Signalquelle (1) anschaltet.

2. Eichleitungs-Anordnung nach Anspruch 1,
**dadurch gekennzeichnet,**
**dass** die Umgehungsleitung (6) als mechanische Eichleitung ausgebildet ist, die mittels mechanischer Schalter zwischen mehreren Dämpfungswerten umschaltbar ist.

3. Eichleitungs-Anordnung nach Anspruch 1 oder 2,
**dadurch gekennzeichnet,**
**dass** die mechanischen Umschalter (3, 4) bistabile Koaxial-Relay-Umschalter sind.

4. Eichleitungs-Anordnung nach Anspruch 1 oder 2,
**dadurch gekennzeichnet,**
**dass** die mechanischen Umschalter (3, 4) Transferschalter sind.

5. Eichleitungs-Anordnung nach einem der vorhergehenden Ansprüche,
**dadurch gekennzeichnet,**
**dass** die Schaltvorrichtung (7) für die mechanischen Umschalter (3, 4) mit der Ausgangsleistungs-Einstelleinrichtung der Signalquelle (1) derart gekoppelt ist, dass oberhalb einer vorbestimmten Ausgangsleistung die Umgehungsleitung (6) und unterhalb dieser vorbestimmten Ausgangsleistung die elektronische Eichleitung (5) zwischen Signalquelle (1) und Ausgang (2) geschaltet ist.

## Claims

1. Attenuator system (10) for adjusting the output power level of an HF signal source (1),
wherein an electronic attenuating line (5) is arranged between the signal source (1) and an output (2) by means of input side and output side mechanical switches (3, 4) and these mechanical switches are switchable such that in one switching position (I) the electronic attenuating line (5) and in the other switching position (II) a direct bypass line (6) is switched between the signal source (1) and the output (2), **characterised in that**
by means of a switching device (7) the mechanical switch (3, 4) can be connected with an overvoltage detector (9) assigned to the output (2) of the signal source (1) such that when a permissible level is exceeded at the output (2) the output side mechanical switch (4) disconnects the electronic attenuating line (5) from the output (2) and the input side mechanical switch (3) connects the electronic attenuating line (5) to the signal source (1).

2. Attenuator system according to claim 1,
**characterised in that**
the bypass line (6) is embodied in the form of a mechanical attenuating line which can be switched between a plurality of attenuation values by means of mechanical switches.

3. Attenuator system according to claim 1 or 2,
**characterised in that**
the mechanical switches (3, 4) are bistable coaxial relay switches.

4. Attenuator system according to claim 1 or 2,
**characterised in that**
the mechanical switches (3, 4) are transfer switches.

5. Attenuator system according to one of the preceding claims,
**characterised in that**
the switching device (7) for the mechanical switches (3, 4) is coupled with the output power level adjusting device of the signal source (1) such that above a predetermined output power level the bypass line (6) and below this predetermined output power level the electronic attenuating line (5) is switched between the signal source (1) and the output (2).

## Revendications

1. Dispositif de circuit d'étalonnage (10) pour régler la capacité de sortie d'une source de signaux HF (1),
dans lequel un circuit d'étalonnage électronique (5) est disposé entre la source de signaux (1) et une sortie (2) par l'intermédiaire de commutateurs mécaniques côté entrée et côté sortie (3, 4) et ces commutateurs mécaniques peuvent être commutés de sorte que le circuit d'étalonnage électronique (5) est commuté dans une première position de commutation (I) et une ligne de dérivation directe (6) est commutée dans l'autre position de commutation (II) entre la source de signaux (1) et la sortie (2),
**caractérisé en ce que**
le commutateur mécanique (3, 4) peut être relié à un détecteur de surtensions (9) associé à la sortie (2) de la source de signaux (1) grâce à un dispositif de commutation (7) de sorte que, en cas de dépassement d'un niveau fiable à la sortie (2), le commutateur mécanique côté sortie (4) coupe le circuit d'étalonnage électronique (5) de la sortie (2) et le commutateur mécanique côté entrée (3) active le circuit d'étalonnage électronique (5) à la source de signaux (1).

2. Dispositif de circuit d'étalonnage selon la revendication 1, **caractérisé en ce que**
la ligne de dérivation (6) est réalisée sous la forme d'un circuit d'étalonnage mécanique, qui peut être commuté entre différentes valeurs d'amortissement grâce aux commutateurs mécaniques.

3. Dispositif de circuit d'étalonnage selon la revendication 1 ou 2, **caractérisé en ce que**
les commutateurs mécaniques (3, 4) sont des commutateurs relais coaxiaux bistables.

4. Dispositif de circuit d'étalonnage selon la revendication 1 ou 2, **caractérisé en ce que**
les commutateurs mécaniques (3, 4) sont des commutateurs de transfert.

5. Dispositif de circuit d'étalonnage selon l'une des revendications précédentes, **caractérisé en ce que**
le dispositif de commutation (7) pour le commutateur mécanique (3, 4) est couplé avec le dispositif de réglage de capacité de sortie de la source de signaux (1) de sorte qu'au-dessus d'une capacité de sortie prédéterminée, la ligne de dérivation (6) est commutée entre la source de signaux (1) et la sortie (2) et au-dessous de cette capacité de sortie prédéterminée, est commuté le circuit d'étalonnage électronique (5) entre la source de signaux (1) et la sortie (2).
